# DEMANDE DE BREVET EUROPEEN

(11) **EP 1 406 307 A1**
(43) Date de publication de la demande: **07.04.2004**
(21) Numéro de dépôt: 03300142.1
(22) Date de dépôt: 02.10.2003
(51) Int. Cl.: H01L 29/732, H01L 29/08

(54) **Circuit intégré à couche enterrée fortement conductrice**

(30) Priorité: 03.10.2002 FR 0212278
(71) Demandeur: ST MICROELECTRONICS S.A., 92120 Montrouge (FR)
(72) Inventeur: Marty, Michel, 38760 Saint Paul de Varces (FR); Coronel, Philippe, 38530 Barraux (FR); Leverd, Francois, 38330 Saint Ismier (FR)
(74) Mandataire: de Beaumont, Michel

(57) **Abrégé**

L'invention concerne un circuit intégré comprenant une couche enterrée de type de conductivité déterminé dans un plan sensiblement parallèle au plan d'une surface principale du circuit, dans lequel la partie médiane de cette couche enterrée (23, 24) est remplie d'un matériau de type métallique (15).

## Description

La présente invention concerne le domaine des circuits intégrés à semiconducteur. Plus particulièrement, la présente invention concerne l'amélioration de la conductivité d'une couche enterrée.

La présente invention sera plus particulièrement exposée dans le cadre de la réalisation d'une couche enterrée de collecteur de transistor bipolaire mais l'homme du métier notera à la lecture de la présente description, et comme cela est souligné à la fin de la présente description, que la présente invention s'applique de façon générale à l'obtention de couches profondes fortement conductrices dans un substrat semiconducteur.

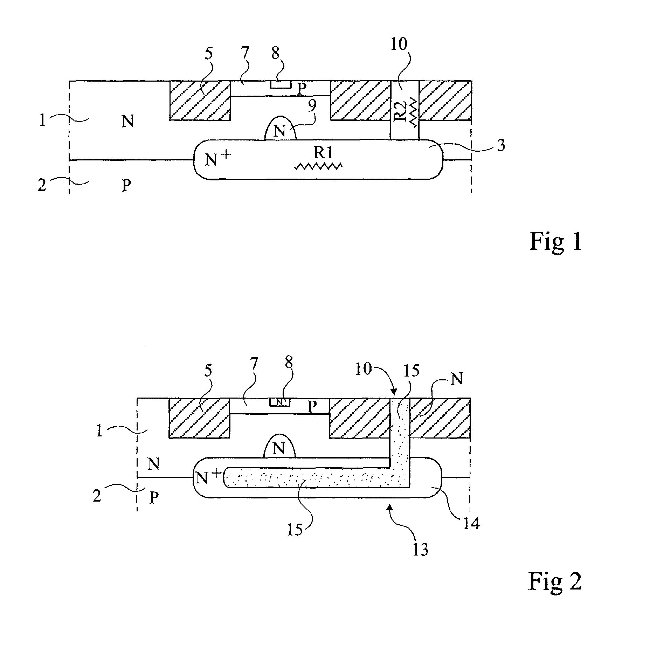

La figure 1 représente de façon très schématique une structure de transistor bipolaire formée dans un substrat semiconducteur. Ce transistor bipolaire est, dans le mode de réalisation particulier décrit, formé dans une couche 1 de type N formée par épitaxie sur un substrat 2 de type P. Sous la zone active où doit être formé le transistor, on aura formé, généralement préalablement à l'épitaxie, une implantation destinée à constituer une couche enterrée 3 fortement dopée de type N. La zone active du transistor est délimitée latéralement par un caisson 5 en oxyde de silicium creusé dans la surface de la couche épitaxiée 1, couramment désigné dans la technique par l'appellation STI, des termes anglo-saxons Shallow Trench Isolation. A l'intérieur de la zone active sont formées une région de base 7 de type P et une région d'émetteur 8 de type N. De nombreux procédés sont connus pour former de telles régions de façon convenablement localisée et pour prendre des contacts sur ces régions. On se référera par exemple au brevet américain 5953600 cédé à la demanderesse (référence du mandataire B3221). Le collecteur du transistor est constitué d'une partie de la couche épitaxiée 1 et d'une zone 9 également de type N implantée en regard de l'émetteur. Le contact de collecteur est repris par la couche enterrée 3 de type N⁺ et par un puits conducteur 10 de type N⁺ traversant le caisson isolant 5 et rejoignant la couche enterrée 3.

Quand on veut faire fonctionner un tel transistor à très haute fréquence, on constate que l'un des paramètres limitant principaux réside dans la résistance d'accès au collecteur, c'est-à-dire la somme de la résistance latérale R1 de la couche enterrée 3 et de la résistance verticale R2 du puits collecteur 10.

Diverses solutions sont connues pour minimiser la résistance du puits collecteur 10, en augmentant fortement le niveau de dopage, en réduisant sa hauteur, ou encore en formant une ouverture et en la remplissant de silicium polycristallin et/ou d'autres matériaux fortement conducteurs. Ainsi, l'élément principal de résistance d'accès au collecteur reste la résistance R1 de la couche enterrée 3. De plus, on ne peut augmenter au maximum le dopage de cette couche, notamment car il se présente des risques d'exodiffusion vers la couche épitaxiée et de création d'une couche fantôme pendant l'épitaxie.

on notera d'ailleurs que la couche enterrée 3 a une double fonction. D'une part, elle permet d'assurer un contact avec la région de collecteur 1, 9, d'autre part, elle est de type de conductivité opposé à celui du substrat sur lequel est formée la couche épitaxiée, de façon à assurer un isolement par jonction et à permettre de polariser convenablement le substrat.

Un objet de la présente invention est de permettre d'augmenter la conductivité d'une couche enterrée tout en maintenant sa double fonction de contact et d'isolement par jonction par rapport au substrat.

Un autre objet de la présente invention est de prévoir divers procédés pour obtenir une telle couche enterrée à conductivité améliorée.

Un autre objet plus particulier de la présente invention est de réaliser la couche enterrée de collecteur et le contact associé pour un transistor bipolaire.

Pour atteindre ces objets, la présente invention prévoit un circuit intégré comprenant une couche enterrée de type de conductivité déterminé dans un plan sensiblement parallèle au plan d'une surface principale du circuit, dans lequel la partie médiane de cette couche enterrée est remplie d'un matériau de type métallique.

Selon un mode de réalisation de la présente invention, la couche enterrée est une couche de sous-collecteur d'un transistor bipolaire.

Selon un mode de réalisation de la présente invention, le matériau de type métallique est du nitrure de titane.

La présente invention prévoit aussi un procédé de formation d'une couche enterrée dans un substrat semiconducteur de circuit intégré, comprenant les étapes consistant à prévoir, à l'emplacement où l'on veut constituer la couche enterrée, une portion de couche en un matériau sélectivement gravable par rapport au reste du matériau semiconducteur, doper le substrat semiconducteur selon un type de conductivité choisi de part et d'autre de ladite portion de couche, creuser une ouverture s'étendant à partir de la surface du circuit intégré jusqu'à ladite portion de couche, éliminer ladite portion de couche par gravure isotrope, et remplir la cavité ainsi formée d'un matériau de type métallique.

Selon un mode de réalisation de la présente invention, la portion de couche est délimitée par un mur isolant.

Selon un mode de réalisation de la présente invention, la portion de couche est une région de silicium-germanium formée par épitaxie sur un substrat de silicium et elle-même recouverte d'une couche épitaxiale de silicium.

Selon un mode de réalisation de la présente invention, la portion de couche est une région d'oxyde de silicium, formée sur un substrat de silicium et revêtue d'une couche de silicium.

Selon un mode de réalisation de la présente invention, la portion de couche est une région évidée formée à l'avance dans le substrat semiconducteur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, décrite précédemment, est une vue en coupe schématique d'un transistor bipolaire selon l'état de la technique ;
la figure 2 est une vue en coupe schématique d'un transistor bipolaire muni d'une couche enterrée selon la présente invention ;
les figures 3A à 3D sont des vues en coupe illustrant des étapes successives d'un premier mode de fabrication d'un transistor selon la présente invention ;
les figures 4A à 4C sont des vues en coupe illustrant des étapes successives d'un deuxième mode de fabrication d'un transistor selon la présente invention ; et
les figures 5A et 5B sont des vues en coupe illustrant des étapes successives d'un troisième mode de fabrication d'un transistor selon la présente invention.

La figure 2 représente un transistor bipolaire incluant une couche enterrée modifiée selon la présente invention. La couche enterrée 3 est remplacée par une couche enterrée 13 dont la périphérie 14 est, comme la couche enterrée 3 de la figure 1, une couche de silicium fortement dopée du type de conductivité souhaité. Toutefois, l'âme de cette couche enterrée est remplacée par une couche 15 fortement conductrice, de préférence une couche de type métallique. Le puits collecteur 10 est de préférence rempli d'un même matériau 15 que celui constituant l'âme de la couche enterrée 13. Le matériau conducteur est par exemple du cuivre déposé par voie électrochimique ou tout autre matériau fortement conducteur adapté à remplir une cavité tel qu'un oxyde conducteur, un siliciure métallique, ou un nitrure de titane ou de tantale, ou autre matériau présentant les mêmes caractéristiques. Le matériau 15 peut également comprendre à sa périphérie un matériau métallique, ou autre matériau fortement conducteur tel qu'un nitrure ou un siliciure et avoir un coeur d'une autre nature, par exemple du silicium polycristallin ou même de l'oxyde de silicium.

Selon la présente invention, étant donné que l'essentiel de la conductivité de la couche enterrée est assuré par l'âme métallique 15, la zone fortement dopée périphérique 14 peut être moins dopée que la couche enterrée 3 de l'art antérieur. En effet, il suffit que cette couche présente un bon contact ohmique avec l'âme métallique 15. On limite ainsi les risques d'exodiffusion vers la couche épitaxiée supérieure pendant l'épitaxie et de création d'une couche fantôme.

La réalisation de couches épitaxiées à âme de type métallique selon la présente invention permet une réduction d'un facteur au moins 10 de la valeur de la résistance R1 présentée en relation avec la figure 1, et permet de réduire le dopage de la région périphérique 14, ce qui simplifie la fabrication. Notamment, si la périphérie 14 est moins dopée que dans l'art antérieur, la dimension de l'extension de la région dopée pendant les recuits diminue, ce qui améliore encore le dispositif.

On va maintenant décrire, uniquement à titre d'exemple, trois modes de réalisation d'une couche enterrée selon la présente invention.

### Exemple 1. Substrat incluant une couche de SiGe

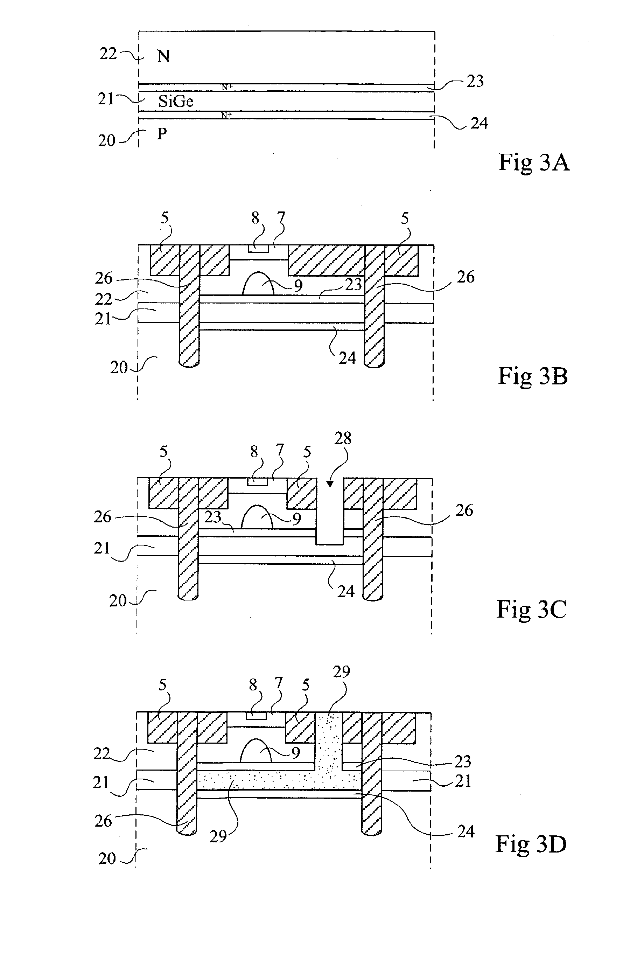

Les figures 3A à 3D illustrent quatre étapes successives d'un premier exemple de fabrication d'une couche enterrée selon la présente invention.

Comme l'illustre la figure 3A, on part d'un substrat 20 de silicium de type P sur lequel a été formée par épitaxie une couche de silicium-germanium (SiGe) 21. Sur la couche 21 est formée par épitaxie une couche de silicium de type N 22. Au moins la partie qui correspondra à la zone active du composant que l'on cherche à fabriquer est encadrée de régions N⁺ 23 et 24. Ceci peut par exemple être obtenu en dopant fortement le SiGe pendant sa croissance épitaxiale, la région N⁺ se formant ensuite par diffusion dans le silicium lors des étapes thermiques ultérieures. On peut également procéder à une implantation après croissance du SiGe ou encore à une implantation profonde après formation de la couche épitaxiée 22. Ces implantations sont de préférence localisées, uniquement sous la région active. De préférence encore, on pourra faire croître successivement une couche de silicium fortement dopé de type N, une couche de germanium-silicium, une couche de silicium fortement dopé de type N, et une couche de silicium faiblement dopé de type N ; l'utilisation d'épitaxies successives permet notamment de réduire les recuits.

Ensuite, comme l'illustre la figure 3B, on réalise les étapes habituelles de formation d'un transistor bipolaire, similaires à celles mentionnées en relation avec la figure 1. Toutefois, dans ce cas, on a également formé en plus du caisson isolant peu profond 5 un mur isolant profond, plus profond que la couche de SiGe 21, désigné par la référence 26. Un premier avantage d'un tel mur isolant est d'éviter que les régions fortement dopées de type N diffusent latéralement vers des composants voisins lors des divers recuits. Ces murs isolants ne sont pas nécessairement totalement remplis d'un isolant, mais éventuellement seules leurs parois extérieures sont revêtues d'un isolant, le reste étant rempli de silicium polycristallin qui est souvent plus facile à déposer. On réalise ensuite, les mêmes éléments que ceux décrits en relation avec la figure 1, à savoir les couches et les contacts de base 7 et d'émetteur 8, et éventuellement une implantation de collecteur 9.

A l'étape illustrée en figure 3C, on réalise une ouverture 28 dans le caisson 5, cette ouverture étant prolongée jusqu'à rejoindre la couche de SiGe 21. On notera qu'en pratique, il existe généralement des couches isolantes supérieures au-dessus de la structure, résultant des procédés de fabrication des régions d'émetteur et de base. Ainsi, l'ouverture 28 traversera également ces couches isolantes non représentées. L'ouverture 28 a été représentée comme pénétrant légèrement dans la couche de SiGe. En pratique, on procédera à une première gravure anisotrope verticale du caisson 5 puis à une deuxième gravure anisotrope verticale du silicium de la couche épitaxiée 22 jusqu'à atteindre la région de SiGe 21.

A l'étape illustrée en figure 3D, on procède à une gravure isotrope par un produit gravant sélectivement le SiGe pour éliminer complètement la portion de couche de SiGe délimitée par le mur 26 et former une cavité à l'emplacement qui était occupé par cette portion de couche. On connaît des procédés isotropes de gravure par plasma du SiGe qui présentent une sélectivité supérieure à 30 entre la gravure du SiGe et la gravure du silicium et de l'oxyde de silicium. Enfin, on dépose par voie chimique en phase vapeur (CVD), ou par des procédés de dépôt atomique couramment appelés dans la technique ALD, du nitrure de titane (TiN) 29 qui remplit la cavité ainsi créée ou au moins en revêt les parois internes. Normalement, on constate que l'on a un remplissage quasi complet par du TiN 29, comme cela est représenté en figure 3D. Pour ce remplissage, on pourrait également utiliser l'un des autres matériaux conducteurs mentionnés précédemment.

### Exemple 2. Substrat de type SOI

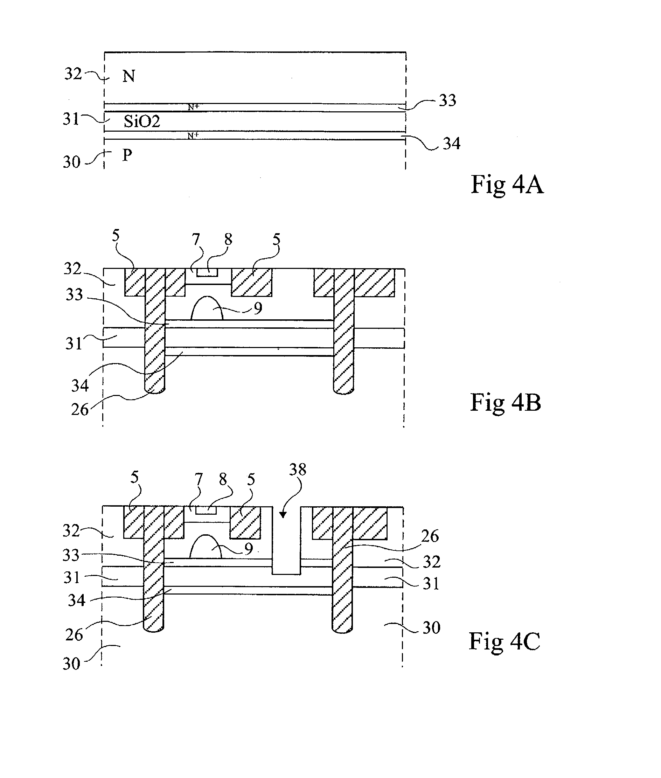

Les figures 4A à 4C illustrent des étapes successives d'un deuxième exemple de fabrication d'une couche enterrée selon la présente invention.

Comme l'illustre la figure 4A, on part d'une structure de type SOI, comprenant un substrat 30, par exemple de silicium de type P, une couche d'oxyde de silicium 31 et une couche épitaxiée 32 de silicium faiblement dopé de type N. La couche d'oxyde 31 est encadrée de régions 33 et 34 fortement dopées de type N obtenues par tout procédé connu, comme cela a été indiqué précédemment. Eventuellement, dans une structure de type SOI obtenue par assemblage de deux plaquettes de silicium, ces régions fortement dopées de type N peuvent être formées avant accolement des deux plaquettes destinées à constituer la structure.

Ensuite, on procède à des étapes similaires à celles décrites en relation avec la figure 3B pour obtenir la structure représentée en figure 4B.

Après cela, comme l'illustre la figure 4C, on procède à la formation d'une ouverture 38 qui s'étend jusqu'à la couche d'oxyde de silicium 31. De préférence, comme cela est représenté en figure 4B, la région où l'on va former l'ouverture 38 est une portion de silicium réservée à l'intérieur du caisson d'oxyde 5. Alors, comme l'illustre la figure 4C, l'ouverture 38 ne rejoint pas les bords du caisson 5 mais est entièrement formée dans le silicium. Ceci présente l'avantage que, à l'étape suivante, pendant laquelle on grave la portion de couche d'oxyde de silicium 21 délimitée par le mur 26, on ne grave pas simultanément les parois du caisson 5. Dans ce cas également, les murs périphériques profonds 26 présenteront de préférence une surface extérieure revêtue de nitrure de silicium pour éviter une gravure de ces murs en même temps que de la région de SiO₂ 31. Dans une dernière phase, l'ouverture 38 et la cavité fournie dans la portion de couche du SiO₂ délimitée par le mur 26 sont remplies d'un matériau bon conducteur comme cela a été décrit dans le cadre du premier exemple.

### Exemple 3. Substrat à cavité pré-formée

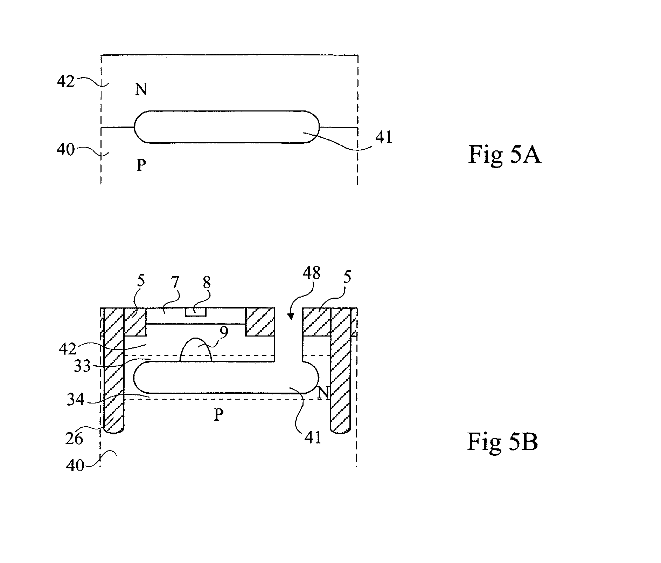

On pourra également, comme le représente la figure 5A, utiliser une structure de silicium comprenant dans un substrat 40 une cavité 41. Une telle cavité 41 peut être formée en gravant dans la surface supérieure du substrat des rainures étroites et rapprochées et en procédant à un recuit à haute température. On constate qu'il se forme alors une cavité sensiblement à l'emplacement du fond des rainures et que la partie supérieure du silicium se rebouche. On procède alors à des traitements de dopage de sorte que la couche 42 au-dessus de la cavité soit faiblement dopée de type N si le substrat est dopé de type P.

Ensuite, on forme de part et d'autre de la cavité une région N fortement dopée, et on procède de la même façon que cela a été décrit précédemment en constituant d'abord les éléments d'un transistor puis en perçant une ouverture 48 qui va rejoindre la cavité 41. On procède alors au remplissage de cette cavité, par exemple par du TiN comme cela a été décrit précédemment. Pour former les régions N fortement dopées autour de la cavité, on pourra, préalablement au remplissage de la cavité, diffuser un dopant de type N, par exemple à partir de silicium polycristallin.

Bien entendu, la présente invention est susceptible de diverses variantes et modifications qui apparaîtront à l'homme de l'art, notamment, en ce qui concerne le choix des matériaux de remplissage et les modes de gravure. L'idée de base de la présente invention étant de créer une portion de couche inhomogène par rapport au silicium monocristallin à l'emplacement où l'on veut former une couche enterrée, puis, après avoir ménagé une ouverture d'accès vers cette région inhomogène de regraver cette région pour y former un vide que l'on remplit ensuite d'un matériau très conducteur. Dans le cadre des deux premiers exemples de fabrication, la portion de couche est une portion d'une couche continue délimitée par un mur périphérique continu. On pourrait aussi prévoir que, avant l'épitaxie de la couche supérieure, on forme directement une portion de couche ayant le contour désiré, par exemple dans une cuvette gravée dans le substrat.

Par ailleurs, la présente invention a été décrite uniquement dans le cadre de la réalisation du collecteur d'un transistor de type NPN. Elle s'appliquera bien entendu à la réalisation d'un collecteur d'un transistor bipolaire de type PNP. Elle s'appliquera plus généralement à la réalisation d'une couche enterrée à très haut niveau de conductivité partout où une telle couche peut être utile. La présente invention s'applique notamment dans le cadre de structures submicroniques dans lesquelles, par exemple, la surface active délimitée par le mur d'isolement profond 26 a une dimension de l'ordre de 0,8 x 1,4 µm² et dans laquelle les épaisseurs de couches ont des valeurs de l'ordre du dixième de micromètre.

On notera que la couche enterrée selon la présente invention est non seulement bonne conductrice électrique mais aussi bonne conductrice thermique. Ainsi, un avantage particulier de la présente invention est que l'on améliore la dissipation thermique du dispositif disposé au-dessus de la couche enterrée. La structure supérieure du puits collecteur pourra être optimisée pour améliorer cette dissipation thermique.

## Revendications

1. Circuit intégré comprenant une couche enterrée de type de conductivité déterminé dans un plan sensiblement parallèle au plan d'une surface principale du circuit, **caractérisé en ce que** la partie médiane de cette couche enterrée est remplie d'un matériau de type métallique (15).

2. Circuit intégré selon la revendication 1, dans lequel ladite couche enterrée est une couche de sous-collecteur d'un transistor bipolaire.

3. Circuit intégré selon la revendication 1, dans lequel ledit matériau de type métallique est du nitrure de titane.

4. Procédé de formation d'une couche enterrée dans un substrat semiconducteur de circuit intégré, comprenant les étapes consistant à :
prévoir, à l'emplacement où l'on veut constituer la couche enterrée, une portion de couche en un matériau sélectivement gravable par rapport au reste du matériau semiconducteur,
doper le substrat semiconducteur selon un type de conductivité choisi de part et d'autre de ladite portion de couche,
creuser une ouverture s'étendant à partir de la surface du circuit intégré jusqu'à ladite portion de couche,
éliminer ladite portion de couche par gravure isotrope, et
remplir la cavité ainsi formée d'un matériau de type métallique (15) .

5. Procédé selon la revendication 4, dans lequel la portion de couche est délimitée par un mur isolant (26).

6. Procédé selon la revendication 4, dans lequel la portion de couche est une région de silicium-germanium formée par épitaxie sur un substrat de silicium et elle-même recouverte d'une couche épitaxiale de silicium.

7. Procédé selon la revendication 4, dans lequel la portion de couche est une région d'oxyde de silicium, formée sur un substrat de silicium et revêtue d'une couche de silicium.

8. Procédé selon la revendication 4, dans lequel la portion de couche est une région évidée formée à l'avance dans le substrat semiconducteur.
